# EUROPEAN PATENT SPECIFICATION

(11) **EP 3 767 687 B1**
(45) Date of publication and mention of the grant of the patent: **28.06.2023**
(21) Application number: 19768430.1
(22) Date of filing: 06.02.2019
(51) Int. Cl.: H01L 31/048, B32B 27/30, B32B 27/36, H01L 31/049

(54) **TRANSPARENT PROTECTIVE SHEET FOR SOLAR CELL MODULE, AND METHOD FOR MANUFACTURING SAME**
TRANSPARENTE SCHUTZFOLIE FÜR SOLARZELLENMODUL UND VERFAHREN ZUR HERSTELLUNG DAVON
FEUILLE DE PROTECTION TRANSPARENTE POUR MODULE DE CELLULES SOLAIRES ET PROCÉDÉ DE FABRICATION ASSOCIÉ

(30) Priority: 14.03.2018 JP 2018046602
(43) Date of publication of application: 20.01.2021
(73) Proprietor: Dai Nippon Printing Co., Ltd., Tokyo 162-8001 (JP)
(72) Inventor: KOYOSHI, Ryosuke, Tokyo 162-8001 (JP); NAKAHARA, Atsushi, Tokyo 162-8001 (JP); ISHII, Yasuhiro, Tokyo 162-8001 (JP)
(74) Representative: Beck Greener LLP
(86) International application number: PCT/JP2019/004264
(87) International publication number: WO 2019/176385

(56) References cited:
- CN-A- 104 479 619
- JP-A- 2011 181 732
- JP-A- 2012 146 698
- JP-A- 2013 093 422
- JP-A- 2014 105 268
- JP-A- 2016 063 139
- JP-A- 2017 069 469

## Description

### TECHNICAL FIELD

The present invention relates to a transparent protective sheet for solar cell module and a method for manufacturing the same.

### BACKGROUND ART

In recent years, solar cells have attracted attention as clean energy sources due to an increasing awareness of environmental issues. In general, a solar cell module configuring a solar cell has a configuration in which a transparent front substrate, a front surface-side sealing material sheet, a solar cell element, a rear surface-side sealing material sheet, and a rear surface protective sheet are laminated sequentially from a light receiving surface side. The solar cell having such a configuration has a function of generating power when sunlight enters the solar cell element. Transparent glass substrates are used in many cases as the transparent front substrate. On the light receiving surface side of the solar cell module, a protective sheet similar to a protective sheet on the rear surface side is usable.

The solar cell module is used outdoors over a long period of time. Therefore, each of the above-described members configuring the solar cell module are required to have durability to withstand severe outdoor environments over a long period of time. In particular, the protective sheet arranged on the outermost surface of the solar cell module is required to have high weatherability. As the protective sheet for the solar cell module is required to have high weatherability as described above, a fluorine-based film has been widely used. However, in response to demands for reducing manufacturing cost and weight, a coating type protective sheet having improved weatherability has been proposed using a polyester-based resin, such as polyethylene terephthalate (PET), as a base material sheet (see Patent Document 1).

Meanwhile, in recent years, a transparent protective sheet having higher transparency while retaining the above-described high weatherability has been required as a so-called see-through type or double-sided lighting type protective sheet for the solar cell module (see Patent Document 2).

The transparent protective sheet for the solar cell module is required to have high-level weatherability and transparency. In order to meet such requirements, a transparent protective sheet has been developed in which a weather resistant resin layer containing a transparent fluorine-based resin is laminated onto a base material resin layer having transparency using a light resistant adhesive layer containing an ultraviolet absorber (see Patent Document 3). In the transparent protective sheet which allows transmission of most of sunlight beams, it is essential to add an ultraviolet absorber to the weather resistant resin layer side as described above in order to protect the base material resin layer from ultraviolet rays.

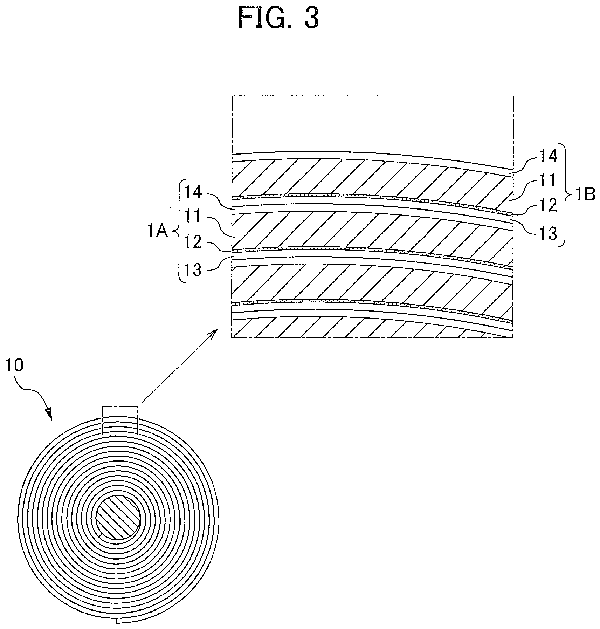

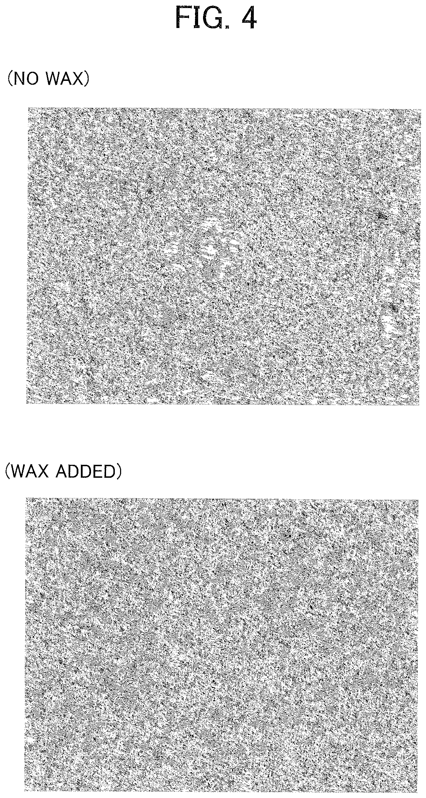

Herein, the transparent protective sheet for solar cell module is usually manufactured on a roll-to-roll manufacturing line which is advantageous in terms of productivity. In the roll-to-roll manufacturing line, the transparent protective sheet is temporarily brought into a roll body state when wound around a winding core (see FIG. 3). In a case of manufacturing a transparent protective sheet having a layer configuration such as the protective sheet disclosed in Patent Document 3, for example, on the roll-to-roll manufacturing line, the frequent occurrence of uneven spots illustrated in FIG. 4 (see top photograph) on the surface of the transparent protective sheet after curing the transparent protective sheet in the roll body state has been recognized as a problem to be solved in the manufacturing of the transparent protective sheet.

The present inventors have found that a main cause of the above-mentioned uneven spots is excessive bleeding of the ultraviolet absorber which is a low molecular weight component in the light resistant adhesive layer. However, the addition of a certain amount or more of the ultraviolet absorber is essential in the transparent protective sheet. Therefore, the addition amount of the ultraviolet absorber cannot be reduced to be less than a certain amount. Thus, other solutions capable of avoiding the occurrence of the uneven spots have been demanded.
Patent Document 1: Japanese Unexamined Patent Application (Translation of PCT Application), Publication No. 2010-519742
Patent Document 2: Japanese Unexamined Patent Application, Publication No. 2012-040842
Patent Document 3: Japanese Unexamined Patent Application, Publication No. 2011-181732

### DISCLOSURE OF THE INVENTION

### Problems to be Solved by the Invention

The present invention has been made in view of the above-described circumstances. More specifically, it is an object of the present invention to avoid, in a transparent protective sheet in which a light resistant adhesive layer containing an ultraviolet absorber is formed on the surface of a base material resin layer, the occurrence of uneven spots on the surface of the transparent protective sheet, which has frequently occurred in a roll-to-roll manufacturing line, while maintaining performance of protecting the base resin layer from ultraviolet rays.

### Means for Solving the Problems

The present inventors have further advanced research on the excessive bleeding of the ultraviolet absorber causing the above-described uneven spots. Thus, the present inventors have proven when the transparent protective sheet having the multilayer configuration described above is in the above-described roll state that the non-uniform pressure applied to the pressing of the base material resin layer having relatively high hardness against the weather resistant resin layer formed of a resin having relatively low hardness, such as a fluorine-based resin, promotes the localized and excessive bleeding of the ultraviolet absorber which is a low molecular weight component onto the surface of the resin layer, which is a more fundamental factor in causing the occurrence of the uneven spots.

Then, the present inventors have found that the above-described problem can be solved by adding an appropriate amount of wax to an easy adhesion layer formed on the surface opposite to the light resistant adhesive layer containing the ultraviolet absorber in the transparent protective sheet of the above-described configuration, and thus have accomplished the present invention. Specifically, the present invention provides the following items.
(1) A transparent protective sheet for solar cell module includes: a weather resistant resin layer laminated on one surface of a base material resin layer using a light resistant adhesive layer; and an easy adhesion layer formed on the other surface of the base material resin layer, in which the base material resin layer is a resin film having a Rockwell hardness according to JIS G 0202 of R80 or more, the weather resistant resin layer is a resin film having the Rockwell hardness according to JIS G 0202 lower than that of the resin film forming the base material resin layer, the light resistant adhesive layer contains 0.3 g/m² or more and 1.3 g/m² or less per unit area of an ultraviolet absorber, and the easy adhesion layer contains 0.07 g/m² or more and 0.25 g/m² or less per unit area of wax.
(2) The transparent protective sheet according to (1), in which the molecular weight of the ultraviolet absorber is 600 or less.
(3) The transparent protective sheet according to (1) or (2), in which the base material resin layer is a polyester-based resin film and the weather resistant resin layer is a fluorine-based resin film.
(4) The transparent protective sheet according to any one of (1) to (3), in which the light transmittance at a wavelength of 400 nm or more and 1200 nm or less is 70% or more.
(5) A transparent protective sheet roll body includes: the transparent protective sheet according to any one of (1) to (4) wound in a roll shape.
(6) A method for manufacturing a transparent protective sheet for solar cell by a roll-to-roll system includes: curing the transparent protective sheet roll body according to (5).
(7) A solar cell module includes: the transparent protective sheet according to any one of (1) to (4) arranged on the outermost surface side and/or the rearmost surface side of the solar cell module.

### Effects of the Invention

The present invention can avoid, in a transparent protective sheet in which a light resistant adhesive layer containing an ultraviolet absorber is formed on the surface of a base material resin layer, the occurrence of uneven spots on the transparent protective sheet surface, which has frequently occurred in a roll-to-roll manufacturing line, while maintaining performance of protecting the base resin layer from ultraviolet rays.

### BRIEF DESCRIPTION OF THE DRAWINGS

FIG. 1 is a cross-sectional view illustrating an example of a layer configuration of a solar cell module containing a transparent protective sheet for solar cell module of the present invention;
FIG. 2 is a cross-sectional view schematically illustrating the layer configuration of the transparent protective sheet for solar cell module of the present invention;
FIG. 3 are cross-sectional views schematically illustrating the layer configuration of a transparent protective sheet roll body of the present invention; and
FIG. 4 are photographs comparing the presence or absence of uneven spots after curing in a roll body between a conventional transparent protective sheet (in which no wax was added: top photograph) and the transparent protective sheet of the present invention (in which a proper amount of wax was added: bottom photograph).

### PREFERRED MODE FOR CARRYING OUT THE INVENTION

Hereinafter, a transparent protective sheet for solar cell module of the present invention and a method for manufacturing the same are described. The present invention is not limited to the embodiment described below.

### <Solar cell module>

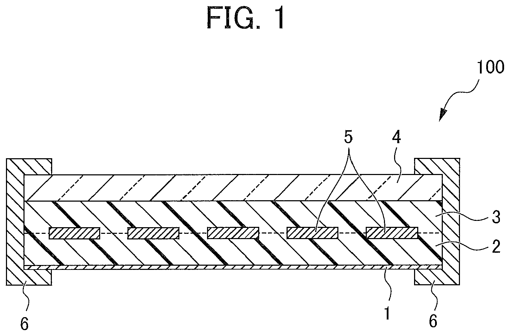

First, the entire configuration of a solar cell module 100 containing a transparent protective sheet 1 for solar cell module of the present invention is described. The solar cell module 100 has a configuration in which a transparent front substrate 4, a front surface-side sealing material sheet 3, solar cell elements 5, a rear surface-side sealing material sheet 2, and the transparent protective sheet 1 are sequentially laminated as illustrated in FIG. 1. Further, metal frames 6 containing aluminum or the like are usually installed on the side peripheral surfaces of this laminate. The intended use of the transparent protective sheet 1 of the present invention is not necessarily limited to the arrangement on the rear surface side of the solar cell module as described above. The transparent protective sheet 1 can also be arranged on the front surface side of the solar cell module 100 as the transparent front substrate for use.

Herein, it is assumed that the solar cell module 100 of the present invention is a solar cell module of a see-through type or a double-sided lighting type. Thus, it is a matter of course that the transparent protective sheet 1 is also required to have high transparency. Herein, in this specification, the term "transparent" refers to the fact that "light beams in a visible light region and a near-infrared region can be transmitted". In more detail, the term "transparent" refers to the fact that "the light transmittance at a wavelength of 400 nm or more and 1200 nm or less is 70% or more and preferably 80% or more in the entire wavelength region". The term "light transmittance" in this specification refers to the light transmittance measured according to JIS-K-7105 or JIS-K-7136 unless otherwise particularly specified.

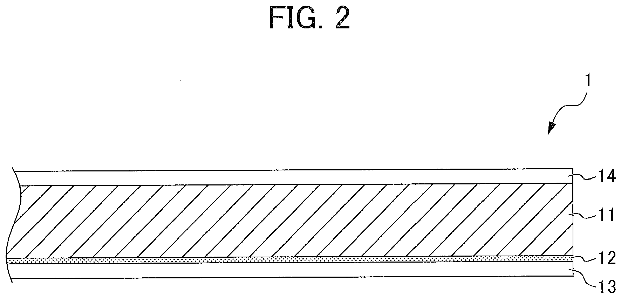

As illustrated in FIG. 2, the transparent protective sheet 1 has a weather resistant resin layer 13 formed on one surface and an easy adhesion layer 14 formed on the other surface. In the solar cell module 100, the transparent protective sheet 1 is arranged such that the bonded surface side of the easy adhesion layer 14 is facing the rear surface-side sealing material sheet 2.

As the rear surface-side sealing material sheet 2 and the front surface-side sealing material sheet 3, sealing materials containing various types of resin conventionally used in solar cell modules can be selected and used as appropriate. A preferable specific example of the sealing material sheets is a sealing material sheet containing an ethylene-vinyl acetate copolymer resin (EVA) or an olefin-based resin, such as polyethylene, as a base resin.

As the transparent front substrate 4, transparent glass substrates are usually used. However, various transparent resin films having weatherability including the transparent protective sheet of the present invention can also be used as the transparent front substrate 4.

### [Method for manufacturing solar cell module]

The solar cell module 100 can be manufactured by integrating the above-described constituents through a thermal press- bonding process, for example, vacuum heat lamination. The lamination temperature at this time is preferably set in the range of 110°C or more and 190°C or less and more preferably 130°C or more. The lamination time is preferably within the range of 5 minutes to 60 minutes. This lamination process is performed in which the easy adhesion layer 14 of the transparent protective sheet 1 and the rear surface-side sealing material sheet 2 are arranged to face each other and thermally press-bonded together. Thus, high adhesiveness of the easy adhesion layer 14 in the interface between the transparent protective sheet 1 and the rear surface-side sealing material sheet 2 can be sufficiently exhibited.

### <Transparent protective sheet>

The transparent protective sheet 1 which can be preferably used for the solar cell module of the see-through type or double-sided lighting type is a resin film of a multilayer configuration including a base material resin layer 11, the light resistant adhesive layer 12, a weather resistant resin layer 13, and the easy adhesion layer 14 as illustrated in FIG. 2. As described above, the weather resistant resin layer 13 is laminated on one surface of the base material resin layer 11 using the light resistant adhesive layer 12 and the easy adhesion layer 14 is formed on the other side of the base material resin layer 11.

For the transparency of the transparent protective sheet 1, it is a specific requirement that the light transmittance at a wavelength of 400 nm or more and 1200 nm or less is 70% or more and preferably 80% or more in the entire wavelength region. In the manufacturing of the transparent protective sheet 1, materials for forming the layers as described in detail below are selected in the range where the requirements can be met. Further, it is essential to include a layer which provides light resistance for protecting the base material resin layer 11 from ultraviolet rays at the same time. In the transparent protective sheet 1, the light resistance is provided by the light resistant adhesive layer 12 containing an ultraviolet absorber.

### [Base material resin layer]

As the base material resin layer 11, various resin films conventionally used for configuring base material resin layers in protective sheets for solar cell module can be used as appropriate. However, in the present invention, a resin film having a Rockwell hardness according to JIS G 0202 (hereinafter also simply referred to as "Rockwell hardness") of R80 is selected among the various resin films. By configuring the base material resin layer 11 which is a support substrate of the transparent protective sheet 1 as a multilayer sheet using a resin film having rigidity equal to or higher than a certain level as described above, defects, such as stretching during drying after application of an adhesive or the like to the base material resin layer 11, are not likely to occur and the handling of work to incorporate the transparent protective sheet 1 into the solar cell module 100 is improved. It is a matter of course that resin films having the Rockwell hardness of 80 or more represented as an equivalent measure of another scale, such as a scale L or a scale M, are also included in the "resin film having the Rockwell hardness according to JIS G 0202 of R80 or more" in this specification.

Specific examples of such resin capable of configuring the base material resin layer 11 include resin films of polypropylene (Rockwell hardness: R85 to 110), polyamide (Rockwell hardness: about R100), polyethylene terephthalate (Rockwell hardness: M94 to 101), polyethylene naphthalate (Rockwell hardness: M107), and the like. Among the above, due to good electrical insulation properties, heat resistance, chemical resistance, dimensional stability, and moldability, polyester-based resin films of polyethylene terephthalate (PET), polyethylene naphthalate (PEN), and the like are preferable and more specifically PET sheets, particularly hydrolysis resistant transparent PET (for example, "Lumirror" (manufactured by Toray Industries, Inc.)), are particularly preferable.

The thickness of the base material resin layer 11 is not particularly limited and is preferably 150 µm or more 300 µm or less and more preferably 200 µm or more. The thickness of the base material resin layer 11 of less than 150 µm is not preferable from the viewpoint of a deterioration in insulation properties. A thickness of more than 300 µm is not preferable from the viewpoint of processing suitability.

When the thickness of the base material resin layer 11 is set to 200 µm or more, the base material resin layer 11 can also be configured using a single-layer resin film having a thickness of 200 µm or more. However, in this case, it is more preferable to configure the base material resin layer 11 using a multilayer film in which a plurality of resin films having a thickness of 100 µm or more is laminated. In general, when a resin film containing PET as a base resin is formed into a thick sheet having a thickness of about 150 µm or more, the draw ratio decreases in film formation, so that the orientation properties of molecules decrease, which increases a risk that the hydrolysis resistance is not sufficiently developed. Further, in this case, curling is sometimes likely to occur during manufacturing due to a difference in orientation between the top layer and the central portion of the resin film. Such a risk can be avoided by forming the base material resin layer 11 as a multilayer film in which a plurality of resin films containing PET having a thickness of 100 µm or more and 150 µm or less as a base resin is laminated.

The base material resin layer 11 may contain components other than the resin described above in the range where the effects of the present invention are not impaired. For example, various plastic compounding agents, additives, other resin, and the like can be added for the purpose of improving and modifying processability, heat resistance, light resistance, weatherability, mechanical properties, dimensional stability, antioxidization properties, sliding property, mold releasability, fire retardancy, antifungal properties, electrical properties, and the like. The addition amount of these additives is not particularly limited. These additives can be arbitrarily added according to the purpose thereof. As common additives, lubricants, crosslinking agents, antioxidants, photostabilizers, fillers, lubricants, reinforced fibers, reinforcing agents, antistatic agents, flame retardants, flame resistant agents, foaming agents, antifungal agents, modifying resin, and the like can be mentioned, for example.

### [Light resistant adhesive layer]

The light resistant adhesive layer 12 is a layer having a function of bonding the weather resistant resin layer 13 to the surface of the base material resin layer 11. This layer is also required to have transparency similar to that of other layers configuring the transparent protective sheet 1. Further, in the transparent protective sheet 1, the light resistant adhesive layer 12 is required to have ultraviolet ray blocking properties for protecting the base material resin layer 11 from ultraviolet rays in addition to transparency. Therefore, a predetermined amount or more of an ultraviolet absorber is added to the light resistant adhesive layer 12. Specifically, in the light resistant adhesive layer 12, the ultraviolet absorber in a proportion of 0.3 g/m² or more and 1.3 g/m² or less per unit area may be added and the ultraviolet absorber in a proportion of 0.5 g/m² or more and 1.0 g/m² or less per unit area is preferably added. Due to the fact that the content of the ultraviolet absorber per unit area is 0.3 g/m² or more, a required ultraviolet ray blocking rate can be ensured. Whereas, when the content of the ultraviolet absorber per unit area exceeds 1.3 g/m², it becomes difficult to sufficiently avoid the occurrence of the uneven spots described above even in the configuration of the present invention and the rate of improvement in the ultraviolet ray blocking performance also decreases in the content range, which increases the risk of economic loss outweighing the cost attributed to the increase in the ultraviolet absorber.

The thickness of the light resistant adhesive layer 12 may be changed as appropriate according to transparency, adhesion strength, and the like required in the transparent protective sheet 1. A range of 1.0 µm or more and 10 µm or less can be mentioned as a preferable thickness range. When the thickness of the light resistant adhesive layer 12 is set to 5.0 µm within the range above, the content of the ultraviolet absorber in the light resistant adhesive layer 12 can be set to 0.38 g/m² in the preferable range above by preparing an adhesive for forming the light resistant adhesive layer 12 such that the content ratio (mass ratio) of the ultraviolet absorber in the layer is 7.5% by mass, i.e., adding the ultraviolet absorber in a compounding ratio of 7.5% by mass with respect to a main agent of the adhesive.

As adhesives as a main material of the adhesive for forming the light resistant adhesive layer 12, various conventionally known additives, such as urethane-based adhesives or acrylic adhesives, can be selected as appropriate insofar as the requirements relating to the transparency are met. Adhesive compositions in which a proper amount of ultraviolet absorber is added to these adhesives are usable as the adhesive for forming the light resistant adhesive layer 12.

As a transparent adhesive as a main material of the light resistant adhesive layer 12, a two-component adhesive containing a main agent containing a mixture of a polyurethane diol and an aliphatic polycarbonate diol and a curing agent is usable, for example. In this case, an adhesive can be preferably used in which both the polyurethane diol and the aliphatic polycarbonate diol configuring the main agent are polyols having hydroxyl groups and react with a curing agent having an isocyanate group.

The polyurethane diol of the main agent component described above is polyurethane having a urethane structure as a repeating unit and having hydroxyl groups at both terminals. The hydroxyl group value of the polyurethane diol is preferably in the range of 10 mg KOH/g or more and 50 mg KOH/g or less. The polyurethane diol is obtained by reacting an aliphatic polycarbonate diol with 1,6 hexanediol, and isophorone diisocyanate in order to improve the adhesiveness and the weatherability of the adhesive as the main agent component of the adhesive.

As the aliphatic polycarbonate diol, commercially-available substances are also usable. In order to obtain adhesives excellent in durability, weatherability, heat resistance, and hydrolysis resistance, aliphatic polycarbonate diol having a number average molecular weight of 1000 (Trade Name "DURANOL T5651", manufactured by Asahi Kasei Chemicals Corporation) and aliphatic polycarbonate diol having a number average molecular weight of 2000 (Trade Name "DURANOL T5662", manufactured by Asahi Kasei Chemicals Corporation) are suitably usable, for example.

As solvents usable when causing aliphatic polycarbonate diol, 1,6 hexanediol, and isophorone diisocyanate to react with one another, those capable of dissolving these compounds and not reacting with solvents can be mentioned without being particularly limited and carboxylic acid ester-based solvents, such as ethyl acetate, can be mentioned from the viewpoint of affinity and processability in lamination.

As the ultraviolet absorber to be added to the adhesive for forming the light resistant adhesive layer 12, various conventionally known organic ultraviolet absorbers can be used as appropriate insofar as the organic ultraviolet absorbers are various ultraviolet absorbers having the absorption maximum in a wavelength of 340 nm to 400 nm. Thus, light beams exceeding 400 nm can be effectively captured, and therefore a deterioration (yellowing) due to ultraviolet absorption of the base material resin layer 11 can be suppressed without reducing the amount of power generated by the solar cell module 100.

However, these ultraviolet absorbers are preferably ultraviolet absorbers having a molecular weight of 600 or less. By specifying the ultraviolet absorber to those of such a low molecular weight, the movement of the ultraviolet absorber to the surface on the weather resistant resin layer 13 side in the light resistant adhesive layer 12 is promoted at higher accuracy, so that the base material resin layer 11 can be more certainly protected from ultraviolet rays entering from the rear surface side of the solar cell module 100.

As the ultraviolet absorber capable of satisfying the above-described requirements, triazine-based ultraviolet absorbers, benzotriazole-based ultraviolet absorbers, and the like can be mentioned, for example. Specific examples of the triazine-based ultraviolet absorbers include 2,4,6-tris[2-hydroxy-4-[1-(isooctyloxycarbonyl)ethoxy]phenyl]-1,3,5-triazine, 2,4-bis[2-hydroxy-4-butoxyphenyl]-6-(2,4-dibutoxyphenyl)-1,3-5-triazine, 2-(2-hydroxy-4-[1-(isooctyloxycarbonyl)ethoxy]phenyl)-4,6-bis(4-phenyl)-1,3,5-triazine, and the like. A preferable specific example of the triazine-based ultraviolet absorbers available on the market includes "TINUVIN405 (manufactured by BASF A.G.)" (molecular weight of 583.76). Similarly, examples of the benzotriazole-based ultraviolet absorbers include "Adekastab LA-29 (manufactured by Adeka Corporation)" (molecular weight of 323) and the like. Two or more types of the ultraviolet absorbers above may be mixed as necessary.

### [Weather resistant resin layer]

The weather resistant resin layer 13 is a layer laminated and arranged on the outermost layer of the transparent protective sheet 1 to protect the base material resin layer 11. The weather resistant resin layer 13 is formed on one surface of the base material resin layer 11 by laminating a resin film having weatherability using the light resistant adhesive layer 12. In order to maintain the transparency of the transparent protective sheet 1, the weather resistant resin layer 13 is also required to have transparency equivalent to that of the base material resin layer 11. As the resin film configuring the weather resistant resin layer 13, various resin films conventionally used as resin films for outermost layer for providing the weatherability in the protective sheet for solar cell module and various resin films capable of satisfying the requirements relating to the transparency are usable. As such resin films, highly flexible fluorine-based resin films having both transparency and excellent weatherability can be preferably used, for example.

As such resin capable of configuring the weather resistant resin layer 13, an ethylene-tetrafluoroethylene copolymer (ETFE): (Rockwell hardness: R50), a tetrafluoroethylene perfluoroalkyl vinyl-ester copolymer (PFA): (Rockwell hardness: R50), polytetrafluoroethylene (PTFE): (Rockwell hardness: R20), and the like can be specifically mentioned as examples. Among the above, due to good transparency and productivity, films containing the ethylene-tetrafluoroethylene copolymer (ETFE) as a base resin (for example, ("AFLEX 25ND", manufactured by Asahi Glass Co., Ltd.)) can be particularly preferably used as the resin film configuring the weather resistant resin layer 13.

As described above, the Rockwell hardness of all the fluorine-based films is about R50 or less. Therefore, in those containing the fluorine-based films above as the weather resistant resin layer 13, the hardness is inevitably lower than that of the base material resin layer 11 to be combined. Thus, one containing the fluorine-based film as the weather resistant resin layer 13 is an example of the typical layer configuration of the present invention.

However, a configuration in which the Rockwell hardness of the weather resistant resin layer 13 is relatively lower than the Rockwell hardness of the base material resin layer 11 is effective in solving the problem of the present invention even when the Rockwell hardness of the weather resistant resin layer 13 exceeds R50. It is a matter of course that a transparent protective sheet having such a layer configuration is also included in the technical scope of the present invention. For example, a combination of PET having the Rockwell hardness of M94 to 101 as the base material resin layer and polyvinylidene fluoride (PVDF) having the Rockwell hardness of R93 to 116 as the layer configuration and the like are equivalent to the layer configuration and the combination and the like are in the technical scope of the present invention.

The thickness of the weather resistant resin layer 13 is not particularly limited. The thickness is preferably in the range of 5 µm or more and 200 µm or less, more preferably in the range of 10 µm or more and 100 µm or less, and most preferably in the range of 20 µm or more and 50 µm or less. When the thickness of the base material resin layer 11 is less than 5 µm, there is a risk that the weatherability is insufficient and the film formation is also difficult, resulting in unfavorable economic feasibility. Whereas, when the thickness exceeds 200 µm, there is a risk that the light transmittance is insufficient, and thus the thickness is not preferable also from the viewpoint of processability or economic feasibility.

To the weather resistant resin layer 13, additionally, various plastic compounding agents, additives, and the like can be added as necessary for the purpose of improving and modifying the processability, heat resistance, weatherability, mechanical properties, dimensional stability, antioxidization properties, sliding property, mold releasability, fire retardancy, antifungal properties, electrical properties, strength, and the like of the sheet, for example. Examples of other additives include dispersants, antifoaming agents, photostabilizers, heat stabilizers, antioxidants, and the like. For these additives, known additives can be used without being particularly limited and are selected as appropriate according to the performance required in the weather resistant resin layer 13.

### [Easy adhesion layer]

The easy adhesion layer 14 is a so-called primer layer and is a layer having a function of improving the adhesiveness of the transparent protective sheet 1 to the rear surface-side sealing material sheet 2 containing an olefin-based resin or the like in the solar cell module 100. As illustrated in FIG. 2, the easy adhesion layer 14 is formed on the other surface opposite to the surface where the weather resistant resin layer 13 is laminated in the base material resin layer 11 of the transparent protective sheet 1. The easy adhesion layer 14 is also required to have transparency equivalent to that of the base material resin layer 11 in order to maintain the transparency of the transparent protective sheet 1.

In the transparent protective sheet 1, the easy adhesion layer 14 further serves to improve the sliding property of the sheet surface when the transparent protective sheet 1 is brought into a roll body state in addition to an adhesiveness improving effect usually imparted to the easy adhesion layer 14. When the transparent protective sheet 1 is in the roll state, pressure applied to the light resistant adhesive layer 12 and the weather resistant resin layer 13 from the base material resin layer 11 is not equally dispersed, and thus, a configuration is adopted which is capable of preventing excessive pressure from being applied partially to the light resistant adhesive layer 12. In order to improve the sliding property, a proper amount of wax is added to the easy adhesion layer 14 as described below in detail.

As a primer composition used in order to form the easy adhesion layer 14, a primer composition is usable which can be obtained by selecting a primer coating liquid capable of satisfying the above-described requirements relating to the transparency among various conventionally known primer coating liquids, and then further adding a proper amount of wax to the primer coating liquid thus selected as described above.

The primer composition forming the easy adhesion layer 14 is not particularly limited. For example, any of a primer composition containing an olefin-based resin and containing an aqueous medium as a main solvent or a primer composition containing a crosslinking main agent resin, a crosslinking agent, and the like and containing an organic medium as a main solvent is selectable and those obtained by further adding a proper amount of wax to these compositions can be used as appropriate. In particular, in the transparent protective sheet 1, the primer composition containing an aqueous medium as a main solvent can be preferably used as the primer composition forming the easy adhesion layer 14. Hereinafter, details of a case where the primer coating liquid containing an aqueous medium as a main solvent (hereinafter also simply referred to as "aqueous primer coating liquid") is used as the primer composition are described.

The easy adhesion layer 14 can be formed by applying the "aqueous primer coating liquid" to one surface of the base material resin layer 11, and then solidifying a coating film containing the applied coating liquid. An easy adhesion layer composition contained in the aqueous primer coating liquid used in order to form the easy adhesion layer 14 is preferably one containing an acid-modified polyolefin resin, which contains an olefin component and an unsaturated carboxylic acid component, as a base resin.

In the acid-modified polyolefin resin, MFR at 190°C and a load of 2.16 kg measured according to JIS K7210 is preferably 0.01 g/10 min or more and less than 100 g/10 min. By using such an acid modified polyolefin resin as a base resin, good dispersibility in the aqueous medium of the easy adhesion layer composition can be easily maintained in the aqueous primer coating liquid used in order to form the easy adhesion layer 14.

Further, by using the acid-modified polyolefin resin as the base resin, the easy adhesion layer 14 with excellent adhesiveness to the olefin-based resin forming the rear surface-side sealing material sheet 2 can also be formed. The fact that the easy adhesion layer 14 of the present invention can remarkably improve the adhesiveness between the base material resin layer 11 containing a polyester-based resin and the rear surface-side sealing material sheet 2 containing an olefin-based resin, for example, is a well-known preferable effect as is clear from the description of Japanese Unexamined Patent Application, Publication No. 2013-74172, for example.

The olefin component as the main component of the acid-modified polyolefin resin is preferably alkene having 2 to 6 carbon atoms, such as ethylene, propylene, isobutylene, 2-butene, 1-butene, 1-pentene, and 1-hexene, and may be a mixture thereof.

The unsaturated carboxylic acid components acid-modifying the olefin component are preferably acrylic acid, methacrylic acid, and the like. The content of the unsaturated carboxylic acid components in the acid-modified polyolefin resin is preferably 0.1% by mass or more and 10% by mass or less and more preferably 0.2% by mass or more and 8% by mass or less. When the content of the unsaturated carboxylic acid components is less than 0.1% by mass, the dispersibility in an aqueous dispersion tends to be insufficient. Whereas, when the content exceeds 10% by mass, the adhesiveness with the olefin-based resin forming the rear surface-side sealing material sheet 2 or the water resistance tends to decrease.

The pH of the aqueous dispersion containing the acid-modified polyolefin resin is preferably in the range of pH 7 to 12 and more preferably in the range of pH 8 to 11 from the viewpoint of dispersion stability.

More specifically, as the acid-modified polyolefin resin, an ethylene-acrylic acid ester-maleic anhydride terpolymer or an ethylene-methacrylic acid ester-maleic anhydride terpolymer or a mixed resin thereof can be preferably used. In addition thereto, ethylene-(meth)acrylic acid ester-maleic anhydride or maleic acid copolymers, such as an ethylene-butyl acrylate-maleic anhydride or maleic acid copolymer, an ethylene-propylene-(meth)acrylic acid ester-maleic anhydride or maleic acid copolymer, an ethylene-butene-(meth)acrylic acid ester-maleic anhydride or maleic acid copolymer, a propylene butene-(meth)acrylic acid ester-maleic anhydride or maleic acid copolymer, an ethylene propylene butene-(meth)acrylic acid ester-maleic anhydride or maleic acid copolymer, an ethylene-acrylic acid copolymer, an ethylene-methacrylic acid copolymer, an ethylene-maleic anhydride copolymer, an ethylene-propylene-maleic anhydride or maleic acid copolymer, an ethylene-butene-maleic anhydride or maleic acid copolymer, a propylene-butene-maleic anhydride or maleic acid copolymer, an ethylene-propylene-butene-maleic anhydride or maleic acid copolymer, and the like are usable.

The acid-modified polyolefin resin described above can be processed into an aqueous dispersion by being dispersed into an aqueous medium. As a dispersion method, known dispersion methods, such as a self-emulsification method and a forced emulsification method, may be adopted. As an aqueous dispersion containing the acid-modified polyolefin resin, an anionic aqueous dispersion obtained by neutralizing the unsaturated carboxylic acid component of the acid-modified polyolefin resin with a basic compound in an aqueous medium is preferable from the viewpoint of adhesiveness.

The transparent protective sheet 1 contains wax as an additive for increasing the sliding property of the surface of the easy adhesion layer 14. The addition of the wax can avoid the occurrence of the uneven spots on the sheet surface in the roll-to-roll manufacturing line which has frequently occurred in a conventional transparent protective sheet having a similar basic configuration.

The wax to be added to the easy adhesion layer 14 is not particularly limited. For example, a plant wax, such as candelilla wax, carnauba wax, rice wax, and tree wax, an animal wax, such as shellac wax and lanolin wax, a mineral wax, such as montan wax and ozocerite, a petroleum wax, such as paraffin wax and microcrystalline wax, and the like can be used as appropriate. Among the above, the paraffin wax is particularly preferable among the above. By adding the paraffin wax in a proper amount range in the easy adhesion layer 14, the occurrence of the uneven spots can be avoided while satisfactorily maintaining the adhesiveness, though the easy adhesion layer 14 is formed using the water primer coating liquid, and further the blocking resistance of the easy adhesion layer 14 can also be improved. The paraffin wax refers to general wax containing linear paraffin-based hydrocarbons having 20 to 30 carbon atoms among organic waxes which are solid at normal temperature and are liquefied when heated. For example, a "paraffin wax aqueous dispersion (EMUSTAR-0135, manufactured by NIPPON SEIRO CO., LTD.)" can be mentioned as a specific example of a preferably usable wax.

In order to improve the sliding property of the surface of the easy adhesion layer 14, the easy adhesion layer 14 contains the wax described above in a predetermined amount range. Specifically, in the easy adhesion layer 14, 0.07 g/m² or more and 0.25 g/m² or less per unit area of wax may be added and 0.10 g/m² or more and 0.18 g/m² or less per unit area of wax is preferably added. Due to the fact that the content of the wax in the easy adhesion layer 14 is 0.07 g/m² or more per unit area, the effect of improving the sliding property described above and the effect of avoiding the occurrence of the uneven spots accompanying therewith can be fully achieved. Whereas, when the content of the wax exceeds 0.25 g/m² per unit area, the risk of impairing the adhesiveness improving effect of the easy adhesion layer 14 increases, and thus the content is not preferable.

The thickness of the easy adhesion layer 14 may be changed as appropriate according to the transparency, adhesion strength, and the like required in the transparent protective sheet 1 and is preferably in the range of 0.2 µm or more and 3.0 µm or less and more preferably in the range of 0.5 µm or more and 1.5 µm or less. When the thickness of the easy adhesion layer 14 is 0.2 µm or more, sufficient adhesiveness can be given to the transparent protective sheet 1. When the thickness of the easy adhesion layer 14 is 3.0 µm or less, good blocking resistance can be given to the transparent protective sheet 1 and the manufacturing cost can also be reduced. The application amount of the aqueous primer coating liquid may be adjusted as appropriate such that the thickness of the easy adhesion layer 14 is in the range above as the application amount after drying. The solid content concentration of the aqueous primer coating liquid which is the aqueous dispersion can be adjusted by the charge composition in preparation and may be adjusted by diluting or concentrating an aqueous dispersion prepared once.

For example, when the thickness of the easy adhesion layer 14 is set to 1.0 µm in the thickness range above, the content of the wax in the easy adhesion layer 14 can be set to 0.15 g/m² in the preferable range above by adding the wax to the aqueous primer coating liquid in such a compounding ratio that the content of the wax is 15% by mass in terms of solid content ratio in the aqueous primer coating liquid.

The aqueous medium used as a main solvent when the acid-modified polyolefin resin or the like is dispersed in the aqueous primer coating liquid used to form the easy adhesion layer 14 is water or a medium containing liquid including water. Specifically, the aqueous medium is used as a main solvent and the content of the aqueous medium with respect to 100 parts by mass of the solvent is more than 50 parts by mass and 100 parts by mass or less and preferably 70 parts by mass or more and 100 part by mass or less.

Further, in the aqueous primer coating liquid, organic solvents having an SP value in a specific range can be further added as an auxiliary solvent in the aqueous dispersion containing the acid-modified polyolefin resin in a range where the effects of the present invention are not impaired. Specifically, when the solvent of the easy adhesion layer composition contains organic solvents as the auxiliary solvent, the content of the organic solvent with respect to 100 parts by mass of the solvent is 0 part by mass or more and less than 50 parts by mass and preferably 0 part by mass or more and less than 30 parts by mass.

### <Method for manufacturing transparent protective sheet>

The transparent protective sheet 1 can be manufactured by first manufacturing a laminate formed by joining a resin film configuring the weather resistant resin layer 13 to the surface of a resin film configuring the base material resin layer 11, and then forming the easy adhesion layer 14 on a surface of the base material resin layer 11 opposite to the surface of the base material resin layer 11 on which the weather resistant resin layer is laminated.

### [Joining between base material resin layer and weather resistant resin layer]

The resin films configuring the base material resin layer 11 and the weather resistant resin layer 13 are joined by a dry lamination method using the light resistant adhesive layer 12 to obtain a laminate in which the base material resin layer 11 and the weather resistant resin layer 13 are integrated. The joining by the dry lamination using the light resistant adhesive layer 12 can be performed by applying the adhesive containing an ultraviolet absorber described above at a proper film thickness to one surface of the resin film configuring the base material resin layer 11, and then laminating the resin film configuring the weather resistant resin layer 13 to the surface of the applied adhesive.

### [Formation of easy adhesion layer]

The primer coating liquid such as the above-mentioned aqueous primer coating liquid is applied onto the surface opposite to the exposed surface of the weather resistant resin layer 13 in the laminate obtained in the above-described step, in which the base material resin layer 11 and the weather resistant resin layer 13 are integrated; and then the primer coating liquid is formed into a coating film to form the easy adhesion layer 14. Examples of coating film formation methods include gravure roll coating, reverse roll coating, wire bar coating, lip coating, air knife coating, curtain flow coating, spray coating, immersion coating, screen printing, a brush coating method, and the like.

### [Curing in roll body state]

The manufacturing method of the present invention is a method on the assumption that the curing processing of promoting the drying of the solvent contained in the applied coating film is performed in a state where a resin film serving as a starting material of the transparent protective sheet is in a roll body state (transparent protective sheet roll body). The transparent protective sheet roll body of the present invention can avoid or remarkably reduce the occurrence of the uneven spots which have frequently occurred after a step of curing such a roll body in a conventional similar roll body.

### <Transparent protective sheet roll body>

FIG. 3 is a partially enlarged view of a roll body end surface for describing the layer configuration of a transparent protective sheet roll body 10 obtained by winding the transparent protective sheet 1 of the present invention in a roll shape. It is assumed that the transparent protective sheet roll body 10 is subjected to prolonged curing in a state where the easy adhesion layer 14 of a transparent protective sheet 1A on the inner peripheral side in contact with the weather resistant resin layer 13 of a transparent protective sheet 1 on the outer peripheral side are press-bonded. At this time, it is supposed that, when the sliding property of the surface of the easy adhesion layer 14 of the transparent protective sheet 1A is insufficient, pressure applied to the weather resistant resin layer 13 of the transparent protective sheet 1B having relatively low hardness becomes nonuniform, so that bleeding of the ultraviolet absorber from the light resistant adhesive layer 12 is locally and excessively advanced. Whereas, in the transparent protective sheet roll body 10, the sliding property of the surface of the easy adhesion layer 14 of the transparent protective sheet 1A is sufficiently improved by the addition of the wax, and therefore the weather resistant resin layer 13 of the transparent protective sheet 1B having relatively low hardness can properly slide, so that the pressure applied to the surface is equally dispersed, and thus the occurrence of the uneven spots as illustrated in the top photograph of FIG. 4 can be prevented. It is a matter of course that roll bodies in a state where both surfaces of the easy adhesion layer 14 of the transparent protective sheet 1A and the weather resistant resin layer 13 of the transparent protective sheet 1A are press-bonded are included in the technical scope of the present invention even when any of the easy adhesion layer 14 of the transparent protective sheet 1A and the weather resistant resin layer 13 of the transparent protective sheet 1A is arranged on the winding core side.

### EXAMPLES

Hereinafter, the present invention is more specifically described by Examples. However, the present invention is not particularly limited to Examples described below at all.

### <Manufacturing of transparent protective sheet>

Transparent protective sheets of Examples and Comparative Examples were manufactured using resin films, material compositions, adhesives, and the like described below. The layer configurations of the transparent protective sheets were all set to the configuration illustrated in FIG. 2, i.e., configuration in which a weather resistant resin layer is joined to one surface of a base material resin layer using an adhesive layer and an easy adhesion layer is formed on the other surface.

### (Base material resin layer)

As a resin film configuring the base material resin layers of the transparent protective sheets of Examples and Comparative Examples, a 300 µm thick hydrolysis resistant polyethylene terephthalate (HR-PET) film (AP (manufactured by Teijin Du Pont Films) was used. The Rockwell hardness of the HR-PET film is R125.

### (Weather resistant resin layer)

As a resin film configuring the weather resistant resin layers of the transparent protective sheets of Examples and Comparative Examples, a 25 µm thick ETFE (ethylene-tetrafluoroethylene copolymer) film (AFLEX 25ND (manufactured by Asahi Glass Co., Ltd.)) was used. The Rockwell hardness of the fluorine-based film is R50.

### (Light resistant adhesive layer)

An adhesive forming the light resistant adhesive layers of the transparent protective sheets of Examples and Comparative Examples was manufactured by steps (a) to (c) of the following method. The joining of the resin films by the manufactured adhesive was performed in the roll-to-roll manufacturing line. The adhesive above was dissolved in an ethyl acetate solvent, and then applied to the surface of the resin film configuring the base material resin layer by gravure coating. The coating amount was applied such that the film thickness after curing of each sheet was of the thickness (µm) illustrated in Table 1.

### (a) Manufacturing of main agent

Under a nitrogen atmosphere, 100 parts by mass of aliphatic polycarbonate diol having a number average molecular weight of 1000 (Trade Name "DURANOL T5651", manufactured by Asahi Kasei Chemicals Corporation), 1,6-hexanediol (5 parts by mass), isophorone diisocyanate (27.5 parts by mass), and ethyl acetate (132.5 parts by mass) were added to a flask having a stirrer, and then heated and refluxed until the absorption of the isocyanate at 2270 cm⁻¹ by an infrared absorption spectrum disappeared to give a 50% aqueous solution of the polyurethane diol. As the aliphatic polycarbonate diol which is a main agent component, aliphatic polycarbonate diol (Trade Name "DURANOL T5651", manufactured by Asahi Kasei Chemicals Corporation) was prepared. A main agent was prepared using the polyurethane diol which is the main agent component manufactured above and the aliphatic polycarbonate diol. This preparation was performed by compounding 15 parts by mass of the aliphatic polycarbonate diol with respect to 100 parts by mass of the polyurethane diol.

### (b) Addition of ultraviolet absorber

: A triazine-based ultraviolet absorber "TINUVIN405 (Trade Name, manufactured by BASF A.G.)" (molecular weight of 583.76) was added to the main agent such that the content of an adhesive in the main agent was each content as illustrated in Table 1 in terms of solid content.

### (c) Manufacturing of curing agent

As materials of a curing agent, a nurate body of isophorone diisocyanate and hexamethylene diisocyanate-based bifunctional polyurethane diisocyanate ("DURANATE D101", manufactured by Asahi Kasei Chemicals Corporation) were used. As the compounding ratio (mass), Nurate body of isophorone diisocyanate:Hexamethylene diisocyanate-based bifunctional polyurethane diisocyanate was set to 40:60. The compounding ratio (mass) was a solid mass ratio not containing a solvent. In manufacturing, the curing agent was prepared such that the solid content was 50%.

### (d) Compounding of main agent and curing agent

An adhesive was manufactured using the main agent and the curing agent manufactured above. The compounding of the main agent and the curing agent was performed by dissolving the base resin and the curing agent in a solvent, and then setting each of them to 50% by mass (ethyl acetate solution). To the curing agent, 3-glycidoxypropyltrimethoxysilane was added as a silane coupling agent in a proportion of 1.2% based on the entire adhesive.

### (Easy adhesion layer)

As described above, a step of forming an easy adhesion layer on the surface of the base material resin layer to which the weather-resistant resin layer was joined (surface opposite to the weather-resistant resin layer) was performed in the roll-to-roll manufacturing line as described above. An aqueous primer coating liquid described below was applied by gravure coating, the applied coating liquid was dried at a drying processing temperature of 110°C for 2 minutes, and then the resultant bifunctional polyurethane was cured at 40°C for 5 days in a roll body state similar to the state described above to promote the curing of the adhesive layer and the formation of the easy adhesion layer to give transparent protective sheets of Examples and Comparative Examples. The application amount of each coating liquid was as illustrated in Table 1. The roll body state is a state where the transparent protective sheet 1000 mm in width and 1000 m in length was wound around a winding core 160 mm in diameter in detail.

As a material of the aqueous primer coating liquid, an aqueous dispersion obtained by stirring and mixing an easy adhesion layer composition containing materials described below and a solvent was used. Acid-modified polyolefin resin : As a base resin, an ready-made acid-modified polyolefin resin powder material ("BONDINE (Registered Trademark)"), manufactured by Tokyo Zairyo Co., Ltd. was used for Examples and Comparative Examples. Paraffin wax
: A "paraffin wax aqueous dispersion (EMUSTAR-0135, manufactured by NIPPON SEIRO CO., LTD.)" was compounded such that the content in the resin component in the easy adhesion layer composition was as illustrated in Table 1 in terms of solid content. Other resin
: "Epocros WS700, manufactured by NIPPON SHOKUBAI Co., Ltd." Added in a proportion of 5 parts by mass to 100 parts by mass of the base resin. Solvent

: A mixed liquid of distilled water (76 parts by mass), isopropanol (23 parts by mass), and triethylamine (1 part by mass) was used as a solvent.

### <Evaluation of transparent protective sheets>

### [Test Example 1: (Transparency evaluation)]

### (Test method)

In order to evaluate the transparency of each transparent protective sheet, the light transmittance at a wavelength of 400 nm or more and 1200 nm or less was measured according to JIS K7361-1:1997 using V670 manufactured by JASCO Corporation. The results are illustrated in Table 1.

### (Evaluation criteria)

O: The light transmittance is 70% or more in the entire wavelength region of 400 nm or more and 1200 nm or less.
×: There is a wavelength region in which the light transmittance is less than 70% in the entire wavelength region of 400 nm or more and 1200 nm or less.

### [Test Example 2: (Design property evaluation)]

A test for evaluating the design property (presence or absence of occurrence of uneven spots) of each transparent protective sheet was performed as follows.

### (Test method)

In order to evaluate the design property of the transparent protective sheets of Examples and Comparative Examples, after the curing in the roll body in the easy adhesion layer formation work described above, the surface of each sheet, which was released from the winding core to be returned to a flat state, was visually observed to confirm the presence or absence of the occurrence of the uneven spots.

### (Evaluation criteria)

O: Visible uneven spots were not observed at all.
Δ: Visible uneven spots were observed in the outside (50 m or less) of the roll (first range of 50 m or less when pulled out from the roll body, which similarly applies to the following description) in the entire surface of a 1000 mm × 1000 mm sample sheet.
×: Visible uneven spots were observed in the outside ( more than 50 m) of the roll in the entire surface of a 1000 mm × 1000 mm sample sheet.

### [Test Example 3: Lightfastness evaluation)]

A test for evaluating the light resistance (ultraviolet ray resistance) of the transparent protective sheet of the present invention was performed as follows.

### (Test method)

The test was performed by placing each transparent protective sheet in a Super UV tester (IWASAKI ELECTRIC CO., LTD., EYESUPER UV TESTER SUV-W151) for 48 hours on condition of 1000 W/m², and then visually observing the surface state of each sheet.

### (Evaluation criteria)

O: Visible yellow discoloration of films was not observed.
×: Visible yellow discoloration of films was observed.

### [Test Example 4: (Adhesiveness evaluation)]

A test for evaluating the adhesiveness of each transparent protective sheet was performed as follows.

### (Test method)

With respect to the transparent protective sheets of Examples and Comparative Examples, a sealing material sheet described below was laminated on the formation surface of the easy adhesion layer using a vacuum laminator for manufacturing a solar cell module under the following lamination conditions to give adhesiveness evaluation samples.

### (Sealing material sheet)

With respect to 100 parts by mass of EVA (Vinyl acetate content of 28%, (Product Name "EVAFLEX/EV250 grade", manufactured by Mitsui Du Pont Polychemical Co., Ltd.), 1.5 parts by mass of a crosslinking agent (Product Name "Lupersol101"), 0.5 part by mass of a crosslinking assistant (TAIC), 0.2 part by mass of an antioxidant (Product Name "NAUGARD-P"), and a UV absorber (compound of 0.1 part by mass of (Product Name "Tinuvin7709") and 0.3 part by mass of (Product Name "Cyasorb UV-531")) were formed into a film 400 µm in thickness by a T-die method at a film forming temperature of 90°C.

### (Lamination conditions)

Lamination was performed under standard curing conditions which involved press-bonding with a vacuum laminator at a pressure of 100 kPa for 15 minutes at 150°C and leaving the thermostat tank to stand at 150°C for 30 minutes. For the adhesiveness evaluation samples, the peeling strength (N) was measured by 180° peeling using a width of 15 mm and an initial value and a value after each durability test were measured. For the measurement, the measurement was performed at 23°C by 180° peeling under a peeling condition of 50 mm/min using a peel tester (Product Name "TENSILON RTA-1150-H", manufactured by "A&D Co., Ltd".), and then an average value of triplicate measurements was adopted.

### (Evaluation criteria)

O: 9 N/15 mm or more
Δ: 6 N/15 mm or more and less than 9 N/15 mm
×: less than 6 N/15 mm

**[Table 1]**

| | Light resistant adhesive layer | | | Easy adhesion layer | | | | | | |
|---|---|---|---|---|---|---|---|---|---|---|
| | Thicknes s (*µ*m) | Ultraviol et absorber content ratio (% by mass) | Ultraviol et absorber content (g/m²) | Thicknes s(µm) | Wax conten t ratio (% by mass) | Wax conten t (g/m ²) | Transparen cy | Light resistanc e | Design propert y | Adhesivene ss |
| Example1 | 5.0 | 7.5 | 0.38 | 1.0 | 15.0 | 0.15 | ○ | ○ | ○ | ○ |
| Example2 | 5.0 | 15.0 | 0.75 | 1.0 | 15.0 | 0.15 | ○ | ○ | ○ | ○ |
| Example3 | 5.0 | 15.0 | 0.75 | 1.0 | 7.5 | 0.08 | ○ | ○ | △ | ○ |
| Exarrple4 | 5.0 | 15.0 | 0.75 | 1.0 | 20.0 | 0.20 | ○ | ○ | ○ | △ |
| Example5 | 7.0 | 15.0 | 1.05 | 1.0 | 15.0 | 0.15 | ○ | ○ | △ | ○ |
| Comparative Example1 | 5.0 | 7.5 | 0.38 | 1.0 | 5.0 | 0.05 | ○ | ○ | × | ○ |
| Comparative Example2 | 5.0 | 15.0 | 0.75 | 1.0 | 5.0 | 0.05 | ○ | ○ | × | ○ |
| Comparative Example3 | 3.0 | 7.5 | 023 | 1.0 | 15.0 | 0.15 | ○ | × | ○ | ○ |
| Comparative Exarrple4 | 5.0 | 15.0 | 0.75 | 1.0 | 35.0 | 0.35 | ○ | ○ | ○ | × |
| Comparative Example5 | 9.5 | 15.0 | 1.43 | 1.0 | 15.0 | 0.15 | ○ | ○ | × | ○ |
| Comparative Example6 | 3.0 | 7.5 | 023 | 1.0 | 0.0 | 0.00 | ○ | × | × | ○ |

It was confirmed from Table 1 that, since the transparent protective sheets of the present invention include the proper light resistant adhesive layer and easy adhesion layer, the light resistance and the adhesive layer are maintained at an excellent level and further, since a proper amount of wax is added to the easy adhesion layer, particularly a deterioration of the design property after passing through the roll body state can be prevented in the manufacture process.

### EXPLANATION OF REFERENCE NUMERALS

1 transparent protective sheet
11 base material resin layer
12 light resistant adhesive layer
13 weather resistant resin layer
14 easy adhesion layer
2 rear surface-side sealing material sheet
3 front surface-side sealing material sheet
4 transparent front substrate
5 solar cell element
6 metal frame
10 transparent protective sheet roll body
100 solar cell module

## Claims

1. A transparent protective sheet (1) for solar cell module (100) comprising:
a weather resistant resin layer (13) laminated on one surface of a base material resin layer (11) using a light resistant adhesive layer (12); and
an easy adhesion layer (14) formed on another surface of the base material resin layer,
**characterised in that** the base material resin layer (11) is a resin film having a Rockwell hardness according to JIS G 0202 of R80 or more,
the weather resistant resin layer (13) is a resin film having the Rockwell hardness lower than the Rockwell hardness of the resin film forming the base material resin layer (11),
the light resistant adhesive layer (12) contains 0.3 g/m² or more and 1.3 g/m² or less per unit area of an ultraviolet absorber, and
the easy adhesion layer (14) contains 0.07 g/m² or more and 0.25 g/m² or less per unit area of wax.

2. The transparent protective sheet (1) according to Claim 1, wherein
a molecular weight of the ultraviolet absorber is 600 or less.

3. The transparent protective sheet (1) according to Claim 1 or 2, wherein
the base material resin layer (11) is a polyester-based resin film, and
the weather resistant resin layer (13) is a fluorine-based resin film.

4. The transparent protective sheet (1) according to any one of Claims 1 to 3, wherein
light transmittance at a wavelength of 400 nm or more and 1200 nm or less is 70% or more.

5. A transparent protective sheet roll body (10) comprising:
the transparent protective sheet (1) according to any one of Claims 1 to 4 wound in a roll shape.

6. A method for manufacturing a transparent protective sheet (1) for solar cell by a roll-to-roll system comprising:
curing the transparent protective sheet roll body (10) according to Claim 5.

7. A solar cell module comprising:
the transparent protective sheet (1) according to any one of Claims 1 to 4 arranged on an outermost surface side and/or a rearmost surface side of the solar cell module (100).

## Patentansprüche

1. - Transparente Schutzfolie (1) für ein Solarzellenmodul (100), umfassend:
eine witterungsbeständige Harzschicht (13), die unter Verwendung einer lichtbeständigen Klebstoffschicht (12) auf eine Fläche einer Basismaterial-Harzschicht (11) laminiert ist, und
eine einfach haftende Schicht (14), die auf einer anderen Fläche der Basismaterial-Harzschicht gebildet ist,
**dadurch gekennzeichnet, dass** die Basismaterial-Harzschicht (11) eine Harzfolie mit einer Rockwell-Härte gemäß JIS G 0202 von R80 oder mehr ist,
die witterungsbeständige Harzschicht (13) eine Harzfolie mit einer geringeren Rockwell-Härte als die Rockwell-Härte der Harzfolie ist, die die Basismaterial-Harzschicht (11) bildet,
die lichtbeständige Klebstoffschicht (12) 0,3 g/m² oder mehr und 1,3 g/m² oder weniger pro Flächeneinheit eines Ultraviolett-Absorptionsmittels enthält, und
die einfach haftende Schicht (14) 0,07 g/m² oder mehr und 0,25 g/m² oder weniger pro Flächeneinheit von Wachs enthält.

2. Transparente Schutzfolie (1) nach Anspruch 1, wobei
ein Molekulargewicht des Ultraviolett-Absorptionsmittels 600 oder weniger beträgt.

3. Transparente Schutzfolie (1) nach Anspruch 1 oder 2, wobei
die Basismaterial-Harzschicht (11) eine Harzfolie auf Polyesterbasis ist, und
die witterungsbeständige Harzschicht (13) eine Harzfolie auf Fluorbasis ist.

4. Transparente Schutzfolie (1) nach einem der Ansprüche 1 bis 3, wobei
die Lichtdurchlässigkeit bei einer Wellenlänge von 400 nm oder mehr und 1200 nm oder weniger 70 % oder mehr beträgt.

5. Rollenkörper (10) einer transparenten Schutzfolie, umfassend:
die transparente Schutzfolie (1) nach einem der Ansprüche 1 bis 4, in Rollenform gewickelt.

6. Verfahren zur Herstellung einer transparenten Schutzfolie (1) für eine Solarzelle durch ein System von nebeneinander angeordneten Rollen, umfassend:
Aushärten des Rollenkörpers (10) der transparenten Schutzfolie nach Anspruch 5.

7. Solarzellenmodul, umfassend:
die transparente Schutzfolie (1) nach einem der Ansprüche 1 bis 4, angeordnet auf einer Seite einer äußersten Fläche und/oder einer Seite einer hintersten Fläche des Solarzellenmoduls (100).

## Revendications

1. Feuille protectrice transparente (1) pour un module de cellule solaire (100) comprenant :
une couche de résine résistante aux intempéries (13) laminée sur une surface d'une couche de résine de matériau de base (11) en utilisant une couche adhésive résistante à la lumière (12) ; et
une couche à adhérence facile (14) formée sur une autre surface de la couche de résine de matériau de base,
**caractérisée en ce que** la couche de résine de matériau de base (11) est un film de résine ayant une dureté Rockwell selon la norme JIS G 0202 de R80 ou plus,
la couche de résine résistante aux intempéries (13) est un film de résine ayant une dureté Rockwell inférieure à la dureté Rockwell du film de résine formant la couche de résine de matériau de base (11),
la couche adhésive résistante à la lumière (12) contient au moins 0,3 g/m² et au plus 1,3 g/m² par unité de surface d'un absorbeur d'ultraviolets, et
la couche à adhésive facile (14) contient au moins 0,07 g/m² et au plus 0,25 g/m² par unité de surface de cire.

2. Feuille protectrice transparente (1) selon la revendication 1, dans laquelle
le poids moléculaire de l'absorbeur d'ultraviolets est d'au plus 600.

3. Feuille protectrice transparente (1) selon la revendication 1 ou 2, dans laquelle
la couche de résine de matériau de base (11) est un film de résine à base de polyester, et
la couche de résine résistante aux intempéries (13) est un film de résine à base de fluor.

4. Feuille protectrice transparente (1) selon l'une quelconque des revendications 1 à 3, dans laquelle
la transmittance lumineuse à une longueur d'onde de 400 nm ou plus et de 1200 nm ou moins est supérieure ou égale à 70 %.

5. Rouleau de feuille protectrice transparente (10) comprenant :
la feuille protectrice transparente (1) selon l'une quelconque des revendications 1 à 4 enroulée sous forme de rouleau.

6. Procédé de fabrication d'une feuille protectrice transparente (1) pour cellule solaire par un système rouleau-à-rouleau comprenant de :
réticuler le rouleau de feuille protectrice transparente (10) selon la revendication 5.

7. Module de cellule solaire comprenant :
la feuille protectrice transparente (1) selon l'une quelconque des revendications 1 à 4 disposée sur la surface la plus externe et/ou la surface la plus à l'arrière du module de cellule solaire (100).
